Europäisches Patentamt

European Patent Office

Office européen des brevets

(11) Publication number: **0 178 146**
A2

# (12) EUROPEAN PATENT APPLICATION

(21) Application number: **85307172.8**

(22) Date of filing: **07.10.85**

(51) Int. Cl.⁴: **H 03 J 7/02**, H 03 D 5/00

(30) Priority: **09.10.84 GB 8425501**

(43) Date of publication of application: **16.04.86**
**Bulletin 86/16**

(84) Designated Contracting States: **DE FR NL SE**

(71) Applicant: **PLESSEY OVERSEAS LIMITED**, Vicarage Lane, Ilford Essex IGI 4AQ (GB)

(72) Inventor: **Lawton, Rodney James**, 18 Washpool Shaw, Swindon Wiltshire (GB)

(74) Representative: **Nicholson, Ronald, Intellectual Property Department The Plessey Company plc 2-60 Vicarage Lane, Ilford Essex IG1 4AQ (GB)**

## (54) Improvements relating to radio receivers.

(57) A radio receiver adapted to provide AM or FM demodulation functions comprising a discriminator and a log detector fed in parallel at intermediate frequency from a mixer, an output power amplifier stage fed selectively via a switch from the discriminator or alternatively from the log detector thereby to provide the function required, and a feed back control line via which the discriminator is coupled to a local oscillator which feeds the mixer whereby the frequency of the local oscillator is controlled.

The radio preferably also includes an exponential amplifier via which the switch is arranged to feed the log detector to afford the AM demodulation function.

The radio has the advantage of affording both AM and FM demodulation functions at low cost in a form which is simple and lends itself to integration techniques.

# IMPROVEMENTS RELATING TO RADIO RECEIVERS

This invention relates to radio receivers.

The present invention is specifically concerned with the provision of AM/FM receivers which have selective switching means operable as required for amplitude or frequency demodulation of received signals and which inter alia are of simple low-cost construction by facilitating the ready adaptation of existing circuits for their fabrication.

According to the present invention there is provided a radio receiver for providing amplitude or frequency demodulation of received signals according to requirements, the receiver comprising a mixer for producing from a received signal and a local oscillator an intermediate frequency signal which is applied to the respective inputs of a discriminator and a log detector, selective switching means operable for connecting either the discriminator or the log detector to an output power amplifier stage according to whether the receiver is to function as an AM or FM receiver and feedback means may, if necessary, be provided between the output of the discriminator and the local oscillator to control the frequency during broad-band FM demodulation operation of the receiver.

The log detector will usually have an exponential amplifier comprising a linearisation network connected between the output side of the detector and the selective switching means of the radio receiver.

By way of example the present invention will now be described with reference to the accompanying single-figure schematic diagram of a radio receiver.

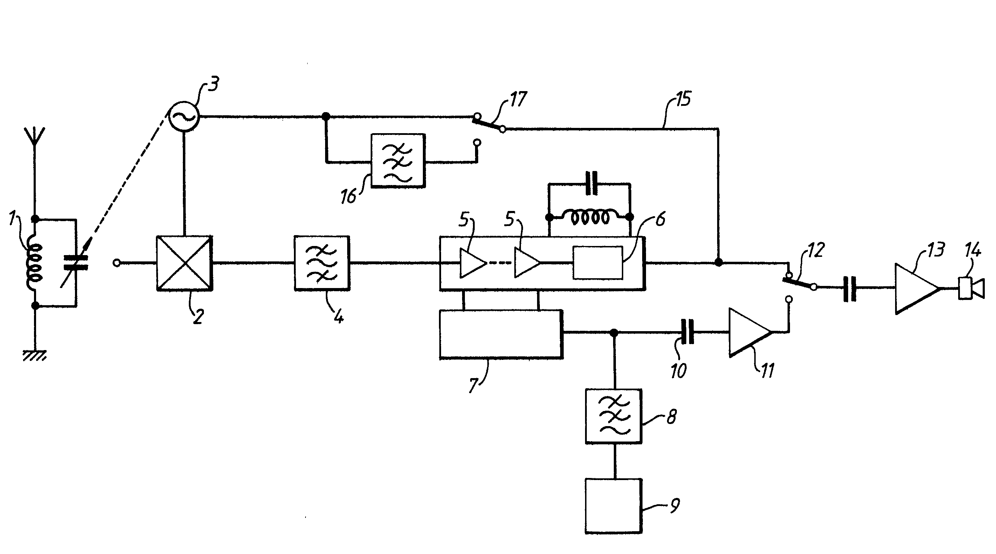

Referring to the drawing the radio receiver comprises a receiving aerial structure 1 the received output signal from which is applied through a mixer 2 which is fed with the output from a local oscillator 3 to produce a signal of intermediate frequency which is applied to a bandpass filter 4. The output signal from the filter 4 is applied through a multi-stage high gain amplifier 5 to a discriminator 6 for frequency demodulation purposes. For amplitude demodulation purposes a log detector 7 is connected across the multi-stage amplifier 5 at distribution points therealong and provides a logarithmic output corresponding to the sum of the amplified intermediate frequency signals derived from the amplifier 5. The output from the log detector 7 is applied through a low passband filter 8 to a signal strength meter 9 which serves to provide an indication of the received signal strength during both FM and AM operation of the receiver.

The output from the log detector 7 is also applied through a filter capacitor 10 to an exponential amplifier 11 which effectively acts as an anti-log or linearisation circuit. This circuit may simply comprise a transistor or it may comprise a suitable linearisation network. Since the capacitor 10 filters out the d.c. components of the

-3-

logarithmic signal so that only the small a.c. components need to be linearised the linearisation range of the exponential amplifier 11 need only be positive/negative 1 octave for 50% AM modulation depth or positive/negative 1 decade for 90% AM modulation depth.

For the purpose of selecting FM or AM operation of the receiver a two position selector switch 12 is provided. When the switch 12 is positioned as shown in the drawing the receiver will operate as a frequency modulation receiver. Consequently, the amplified IF signal applied to the input of the discriminator 6 will be frequency demodulated and the output from the discriminator fed through the switch 12 to a power amplifier stage 13 the output from which operates a loudspeaker 14. The frequency demodulated output signal from the discriminator 6 is also applied over a feedback path 15 to the local oscillator 3 in order to control the output frequency thereof during frequency demodulation and thereby reduce peak-to-peak deviation of the received FM signal from 100 Khz to 5Khz (i.e. the passband of the filter 4).

When the receiver is to function as an amplitude demodulator then the switch 12 will be operated to its other switching position so that the output from the log detector 7 which effectively operates as an amplitude demodulator will be linearised by the exponential amplifier 11 and applied by the switch 12 to the power amplifier stage 13 and the loudspeaker 14.

0178146

-4-

Also during AM operation of the receiver a low passband filter 16 may be introduced into the feedback path 15 by the operation of a switch 17 for narrow band control of the local oscillator 3. The switch 17 may be ganged to the selector switch 12 for selecting FM/AM operation of the receiver.

As will be appreciated from the foregoing the output from the log detector will be fed through the low-pass filter 8 to the signal strength meter 9 during FM as well as AM operation of the receiver in order to provide an indication of the strength of the received signal.

It may also be mentioned that when the output from the log detector falls rapidly transient noise may be produced. In order to avoid this a positive/negative clipper or limiter may be introduced in the AM circuit path.

As will of course be understood, the filter 4 necessarily has a narrow passband (e.g. 5Khz) for AM operation of the receiver but the feedback control arrangement provided in the specific embodiment described enables the receiver also to be operated as an FM receiver to receive broadband FM signals (e.g. 100Khz bandwidth). If the receiver is only required for AM operation and narrow band FM operation (e.g. 5Khz) then the feedback path may be dispensed with.

It may also be mentioned here that the FM/AM receiver according to the invention may readily be constructed by simple additions to and adaptation of existing FM receivers.

In such receivers log detectors are coupled to the multi-stage high gain amplifier preceding the FM discriminator but these log detectors are utilised purely to provide logarithmic outputs for signal strength evaluation by signal strength meters. The present invention recognises that by linearising these outputs and by introducing a low pass filter between the mixer and the multi-stage amplifier the receiver can alternatively be used for AM operation and selective switching means provided to make the appropriate selection. The introduction of feedback path means then renders the receiver still suitable for broadband FM operation. Thus it will be appreciated that the present invention facilitates by such simple adaptation of and addition to existing FM receivers the provision of a simple, low-cost FM/AM receiver.

Another advantage of the FM/AM receiver according to the invention is that an AGC facility is not required since the demodulated AM signal derived from the log detector and exponential amplifier is independent of the absolute signal strength for a given signal modulation index of received signal.

CLAIMS:

1.   A radio receiver for providing amplitude or frequency demodulation of received signals according to requirements, the receiver comprising a mixer for producing from a received signal and a local oscillator an intermediate frequency signal which is applied to the respective inputs of a discriminator and a log detector, selective switching means operable for connecting either the discriminator or the log detector to an output power amplifier stage according to whether the receiver is to function as an AM or FM receiver.

2.   A radio receiver as claimed in claim 1, in which feedback means is provided between the output of the discriminator and the local oscillator to control the frequency during broadband FM demodulation operation of the receiver.

3.   A radio receiver as claimed in claim 1 or claim 2, in which the log detector has an exponential amplifier comprising a linearisation transistor or network connected between the output side of the detector and the selective switching means of the radio receiver.

4.    A radio receiver as claimed in any preceding claim, in which a narrow band filter is connected between the mixer and the disriminator.

5.    A radio receiver as claimed in any preceding claim, in which the discriminator is preceded by a multi-stage amplifier and in which the log detector is connected to distributed points of the amplifier to provide a logarithmic summation output.

6.    A radio receiver as claimed in any preceding claim, in which the output from the log detector is applied to a signal strength meter to provide an indication of signal strength during both AM and FM operation of the receiver.